# EUROPEAN PATENT APPLICATION

(11) **EP 4 672 920 A2**
(43) Date of publication of application: **31.12.2025**
(21) Application number: 25209251.5
(22) Date of filing: 16.10.2025
(51) Int. Cl.: H10F 10/166, H10F 10/165, H10F 71/00, H10F 77/20, H10F 77/30, H10F 77/70

(54) **BACK CONTACT SOLAR CELL AND MANUFACTURING METHOD THEREOF**

(30) Priority: 09.06.2025 CN 202510764102
(71) Applicant: Zhejiang Jinko Solar Co., Ltd., Haining, Zhejiang 314416 (CN)
(72) Inventor: DUAN, Weiyuan, 314416 Haining, Zhejiang (CN); SUN, Yufeng, 314416 Haining, Zhejiang (CN); YUE, Haodong, 314416 Haining, Zhejiang (CN); YANG, Jie, 314416 Haining, Zhejiang (CN); ZHANG, Xinyu, 314416 Haining, Zhejiang (CN)
(74) Representative: Ipsilon

(57) **Abstract**

The present application relates to a back contact solar cell and a manufacturing method thereof. The back contact solar cell includes: a semiconductor substrate including a front side and a back side; a first semiconductor layer and a second semiconductor layer alternately arranged over the back side, with their edges forming an overlapping region, a first groove being formed between adjacent second semiconductor layers, a second groove being provided on an outer surface of the second semiconductor layer, and a conductivity type of the second semiconductor layer being opposite to that of the first semiconductor layer; and a conductive film layer disposed over outer surfaces of the first groove, the second groove, and the overlapping region. The conductive film layer is provided with two first isolation regions at a groove bottom of the second groove. The first isolation region includes at least one first isolation groove.

## Description

### TECHNICAL FIELD

The present application relates to the technical field of solar cells, particularly to a back contact solar cell and a manufacturing method thereof.

### BACKGROUND

In a conventional back contact hybrid solar cell, a first region's semiconductor layer mainly including a tunneling oxide layer/a doped polysilicon layer and a second region's semiconductor layer mainly including an intrinsic amorphous silicon layer/a doped amorphous silicon layer are alternately arranged over a back side of the solar cell, with the semiconductor layer in each region connected to a transparent electrode.

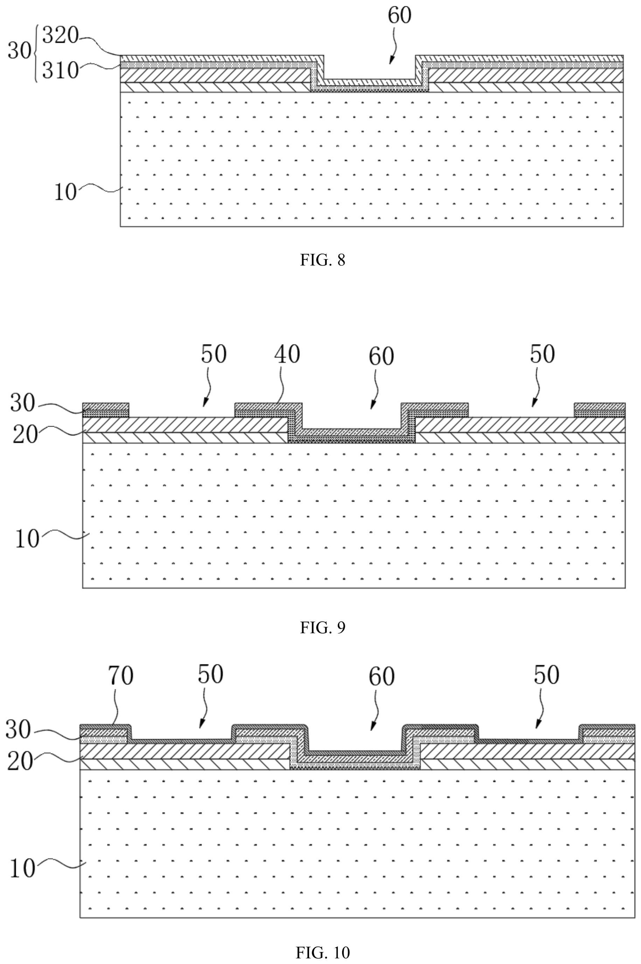

In the related art, Chinese patent CN 117577709 B describes a back contact solar cell, where an isolation region (as indicated with *Wa* in FIG. 8) of a transparent conductive layer extends across an edge of a P-region (as indicated with *W2* in FIG. 8), an edge of an N-region (as indicated with *W1* in FIG. 8), and an overlapping region thereof. However, this configuration leads to a significant loss of area in the transparent conductive layer. Additionally, the process of removing a part of the transparent conductive layer to form the isolation region often leads to etching of the underlying film(s), which in turn reduces the efficiency of the solar cell.

### SUMMARY

In view of above, there is a need to provide a back contact solar cell with an improved conversion efficiency. In addition, a method for manufacturing a back contact solar cell is also provided.

In a first aspect of the present application, a back contact solar cell is provided, including: a semiconductor substrate including a front side and a back side; a first semiconductor layer and a second semiconductor layer alternately arranged over the back side in an X-axis direction, an edge of the first semiconductor layer and an edge of the second semiconductor layer forming an overlapping region in a Z-axis direction, a first groove being formed between adjacent second semiconductor layers, a second groove being provided on an outer surface of the second semiconductor layer, and a conductivity type of the second semiconductor layer being opposite to a conductivity type of the first semiconductor layer; and a conductive film layer disposed over outer surfaces of the first groove, the second groove, and the overlapping region. The conductive film layer is provided with two first isolation regions spaced apart from each other at a groove bottom of the second groove. Each of the two first isolation regions includes at least one first isolation groove spaced apart in the X-axis direction.

In some embodiments, a distance between two adjacent first isolation grooves in either of the two first isolation regions in the X-axis direction is 5 µm to 15 µm.

In some embodiments, a part of the second semiconductor layer between the two first isolation regions in the same second groove includes a microcrystalline silicon region, and a distance between the microcrystalline silicon region and either of the two first isolation regions in the X-axis direction is less than 5 µm.

In some embodiments, parts of the conductive film layer on two opposite side walls of the second groove each form a slope inclined toward a top of the overlapping region adjacent thereto. In the X-axis direction, a width of the overlapping region is 10 µm to 160 µm, a width of the slope is 5µm to 20 µm, a width of the first isolation groove is 35µm to 80 µm, and a width of the microcrystalline silicon region is 300 µm to 600 µm.

In some embodiments, a part of the second semiconductor layer between the two first isolation regions in the same second groove is an amorphous silicon region.

In some embodiments, parts of the conductive film layer on two opposite side walls of the second groove each form a slope inclined toward a top of the overlapping region adjacent thereto. In the X-axis direction, the two first isolation regions in the same second groove are each adjacent to the respective slope. The two first isolation regions have their starting points located farther away from each other and their ending points located closer to each other. A distance between either of the starting points of the two first isolation regions and a slope bottom of the adjacent slope is 0 µm to 3 µm.

In some embodiments, the conductive film layer is provided with a second isolation region at a position corresponding to a top of the overlapping region. The second isolation region includes at least one second isolation groove spaced apart in the X-axis direction.

In some embodiments, a width of the second isolation groove in the X-axis direction is 0 µm to 80 µm.

In some embodiments, a distance between two adjacent second isolation grooves in the same second isolation region is 10 µm to 30 µm.

In some embodiments, the conductive film layer is provided with a third isolation region at a position corresponding to a side wall of the second groove.

In a second aspect of the present application, a method for manufacturing a back contact solar cell is provided, including: S 10, forming a first semiconductor layer and a mask layer sequentially over a back side of a semiconductor substrate; S20, removing parts of the first semiconductor layer and the mask layer corresponding thereto in a first predetermined region on a back side of an intermediate structure obtained in S10 to form a recessed region; S30, forming a textured surface at a bottom of the recessed region, and removing the remaining part of the mask layer; S40, forming a second semiconductor layer over a back side of an intermediate structure obtained in S30, with an outer surface of the second semiconductor layer forming a second groove at a position corresponding to the recessed region; S50, removing a part of the second semiconductor layer in a second predetermined region on a back side of an intermediate structure obtained in S40 to form a first groove spaced apart from the second groove, with an edge of the first semiconductor layer and an edge of the second semiconductor layer forming an overlapping region; S60, forming a conductive film layer over a back side of an intermediate structure obtained in S50; and S70, performing an opening-etching process on a third predetermined region of a back side of an intermediate structure obtained in S60, to form two first isolation regions spaced apart on the conductive film layer at a groove bottom of the second groove, with each of the two first isolation regions including at least one first isolation groove spaced apart in an X-axis direction.

In some embodiments, the S40 includes: forming a passivation layer over the back side of the intermediate structure obtained in S30; and forming an amorphous silicon layer on the passivation layer.

In some embodiments, the S50 includes: removing parts of the passivation layer and the amorphous silicon layer in the second predetermined region; and performing a laser scanning on a predetermined region of the amorphous silicon layer in the second groove to form a microcrystalline silicon region.

In some embodiments, the method further includes: performing an opening-etching process on a fourth predetermined region on the back side of the intermediate structure obtained in S60 to form a second isolation region on the conductive film layer at a top of the overlapping region.

In some embodiments, the method further includes: performing an opening-etching process on a fifth predetermined region on the back side of the intermediate structure obtained in S60 to form a third isolation region on the conductive film layer at a position corresponding to a side wall of the second groove.

In the present application, the first isolation region is provided within the second groove on the outer surface of the second semiconductor layer, avoiding an excessive etching of the conductive film layer which may cause a decrease in the bifaciality of the solar cell, thereby improving the conversion efficiency. The first isolation groove causes the conductive film layer to form one or more isolated islands of conductive film layer, resulting in formation of localized electric leakage of the conductive film layer in the first isolation region, which is advantageous for reducing the hot spot effect of the back contact solar cell. Consequently, the back contact solar cell of the present application can achieve improved conversion efficiency and reduced hot spot effect.

### BRIEF DESCRIPTION OF THE DRAWINGS

FIG. 1 is a partial cross-sectional schematic structural view of a back contact solar cell according to an embodiment of the present application.
FIG. 2 is an enlarged view of region A in FIG. 1.
FIG. 3 is an enlarged view of region B in FIG. 1.
FIG. 4 is a schematic flowchart of a manufacturing method of a back contact solar cell according to an embodiment of the present application.
FIG. 5 is a schematic view of a structure obtained after a step S10 of the manufacturing method of the present application.
FIG. 6 is a schematic view of a structure obtained after a step S20 of the manufacturing method of the present application.
FIG. 7 is a schematic view of a structure obtained after a step S30 of the manufacturing method of the present application.
FIG. 8 is a schematic view of a structure obtained after a step S40 of the manufacturing method of the present application.
FIG. 9 is a schematic view of a structure obtained after a step S50 of the manufacturing method of the present application.
FIG. 10 is a schematic view of a structure obtained after a step S60 of the manufacturing method of the present application.
FIG. 11 is a schematic view of a structure obtained after a step S70 of the manufacturing method of the present application.
FIG. 12 is an enlarged view of region C in FIG. 11.
FIG. 13 is a schematic flowchart of an implementation method of the step S40 according to an embodiment of the present application.
FIG. 14 is a schematic flowchart of an implementation method of the step S50 according to an embodiment of the present application.
FIG. 15 is a schematic flowchart of an implementation method of a step S80 and a step S90 according to an embodiment of the present application.

Reference numerals:
100, back contact solar cell; 10, semiconductor substrate; 101, front side; 102, back side; 110, recessed region; 111, textured surface; 20, first semiconductor layer; 210, tunneling oxide layer; 220, intrinsic polysilicon layer; 30, second semiconductor layer; 301, crystallized microcrystalline silicon region; 310, passivation layer; 320, amorphous silicon layer; 40, overlapping region; 401, top; 50, first groove; 60, second groove; 601, side wall; 70, conductive film layer; 701, slope bottom; 710, first isolation region; 711, first isolation groove; 720, second isolation region; 721, second isolation groove; 730, third isolation region; 80, mask layer; 910, first electrode; 920, second electrode.

### DETAILED DESCRIPTION

In the description of the present application, it should be understood that the terms "central", "longitudinal", "transverse", "length", "width", "thickness", "upper", "lower", "front", "rear", "left", "right", "vertical", "horizontal", "top", "bottom", "inner", "outer", "clockwise", "counterclockwise", "axial", "radial", "circumferential", etc. indicate the orientations or positional relationships on the basis of the drawings. These terms are only for describing the present application and simplifying the description, rather than indicating or implying that the related devices or elements must have the specific orientations, or be constructed or operated in the specific orientations, and therefore cannot be understood as limitations of the present application.

In addition, the terms "first" and "second" are merely used for descriptive purposes, and should not be construed as indicating or implying relative importance or implying the quantity of the described technical features. Therefore, the features modified by "first" or "second" may explicitly or implicitly include at least one of the features. In the description of the present application, "a plurality of" means at least two, such as two, three, etc., unless otherwise expressly and specifically defined.

In the present application, unless otherwise clearly specified and defined, the terms "installed", "connected", "coupled", "fixed" and the like should be interpreted broadly. For example, an element, when being referred to as being "installed", "connected", "coupled", "fixed" to another element, unless otherwise specifically defined, may be fixedly connected, detachably connected, or integrated to the other element, may be mechanically connected or electrically connected to the other element, may be directly connected to the other element or connected to the other element via an intermediate element, and may be in internal communication with or in interaction with the other element. For those of ordinary skill in the art, the specific meaning of the above-mentioned terms in the present application can be understood according to specific circumstances.

In the present application, unless otherwise clearly specified and defined, an element, when being referred to as being arranged "on", "over", or "under" another element, may be in direct contact with the other element or contact the other element via an intermediate element. Moreover, the element, when being referred to as being arranged "on", "above", "over" another element, may be arranged right above or obliquely above the other element, or merely arranged at a horizontal level higher than the other element; the element, when being referred to as being arranged "under", "below", "beneath" another element, may be arranged right below or obliquely below the other element, or merely arranged at a horizontal level lower than the other element.

It should be noted that an element, when being referred to as being "fixed" or "mounted" to another element, may be fixed or mounted to the other element directly or via an intermediate element. An element, when being referred to as being "connected" to another element, may be connected to the other element directly or via an intermediate element. Such terms as "vertical", "horizontal", "up", "down", "left", "right" and the like used herein are for illustrative purposes only and are not meant to be the only ways for implementing the present application.

Unless otherwise indicated in the context, layers of the materials described herein may be formed through any suitable techniques, including, but not limited to, spin coating, blanket coating, chemical vapor deposition (CVD), plasma enhanced chemical vapor deposition (PECVD), atomic layer deposition (ALD), plasma enhanced atomic layer deposition (PEALD), physical vapor deposition (PVD) (e.g., sputtering coating), or epitaxial growth. Depending on the particular material of the layer to be formed, the technique used for depositing or growing the material may be selected by one of ordinary skill in the art.

In addition, unless otherwise indicated in the context, the material removal described herein may be achieved through any suitable techniques, including, but not limited to, etching (e.g., dry etching, wet etching, and gas-phase etching), ion milling, grinding planarization (e.g., chemical mechanical planarization (CMP)), or other known methods.

The term "semiconductor" used herein may refer to, for example, a material layer, a base, a wafer, or a substrate, and includes any base semiconductor structure. It should be understood that "semiconductor" may include silicon on sapphire (SOS) technology, silicon on insulator (SOI) technology, thin-film transistor (TFT) technology, doped and undoped semiconductors, epitaxial silicon layers supported by base semiconductor structures, or other semiconductor structures known by one of ordinary skill in the art.

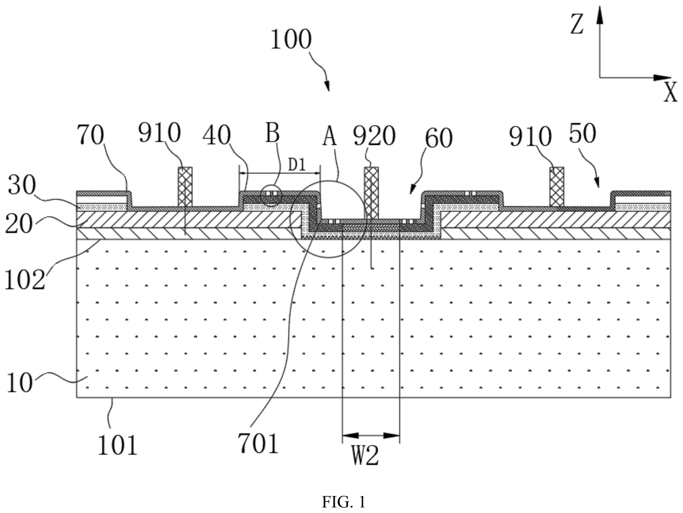

In a first aspect of the present application, referring to FIGS. 1 to 3, a back contact solar cell 100 is provided according to embodiments of the present application. The back contact solar cell 100 includes a semiconductor substrate 10, a first semiconductor layer 20, a second semiconductor layer 30, and a conductive film layer 70.

The semiconductor substrate 10 includes a front side 101 and a back side 102. Herein, the back side 102 is a backlight side, referring to the side of the back contact solar cell 100 that faces away from the sun during operation. The front side 101 is the side of the back contact solar cell 100 that faces the sun during operation. The semiconductor substrate 10 is configured to receive incident lights and produce photogenerated carriers. The semiconductor substrate 10 may be made of a material such as silicon, germanium, germanium-silicon, or silicon on insulator, as well as various types of doped silicon, including but not limited to, boron-doped, phosphorus-doped, gallium-doped, antimony-doped, other element-doped, or mixed-doped silicon.

The first semiconductor layer 20 and the second semiconductor layer 30 are alternately arranged over the back side 102 along an X-axis direction. An edge of the first semiconductor layer 20 and an edge of the second semiconductor layer 30 form an overlapping region 40 in a Z-axis direction. A first groove 50 is formed between adjacent second semiconductor layers 30. An outer surface of the second semiconductor layer 30 is provided with a second groove 60.

The X-axis direction is a direction parallel to the back side 102. The Z-axis direction is a direction perpendicular to the back side 102. In the present application, edges of the second semiconductor layer 30 at both ends thereof respectively extend outwardly to cover the edges of the adjacent first semiconductor layers 20 to form the overlapping regions 40. The first semiconductor layer 20 is exposed through the first groove 50, allowing it to establish an ohmic contact with the first electrode 910.

The second semiconductor layer 30 has a conductivity type opposite to that of the first semiconductor layer 20. Specifically, the second semiconductor layer 30 is a P-type doped semiconductor layer, with the doping element being a P-type doping element such as boron. The first semiconductor layer 20 is an N-type doping semiconductor layer, with the doping element being an N-type doping element such as antimony.

The material of the conductive film layer 70 may refer to a corresponding type in the prior art. For example, the material of the conductive film layer 70 may be an indium oxide-based film doped with at least one of tin, zinc, tungsten, titanium, etc. The conductive film layer 70 is disposed over outer surfaces of the first groove 50, the second groove 60, and the overlapping region 40. The conductive film layer 70 is provided with two first isolation regions 710 spaced apart from each other at a position corresponding to a groove bottom of the second groove 60. Each of the first isolation region 710 includes at least one first isolation groove 711 (e.g., at least two first isolation grooves 711) spaced apart from each other in the X-axis direction.

Specifically, the outer surface of the first groove 50 (including a bottom wall and side walls of the first groove 50), the outer surface of the second groove 60 (including a groove bottom and side walls 601 of the second groove 60), and the outer surface of the overlapping region 40 are all covered by the conductive film layer 70. As both ends of the second semiconductor layer 30 respectively extend outwardly to cover the ends of the adjacent first semiconductor layers 20 to form the overlapping regions 40, the side walls 601 of the second groove 60 are also the side walls 601 of the overlapping regions 40.

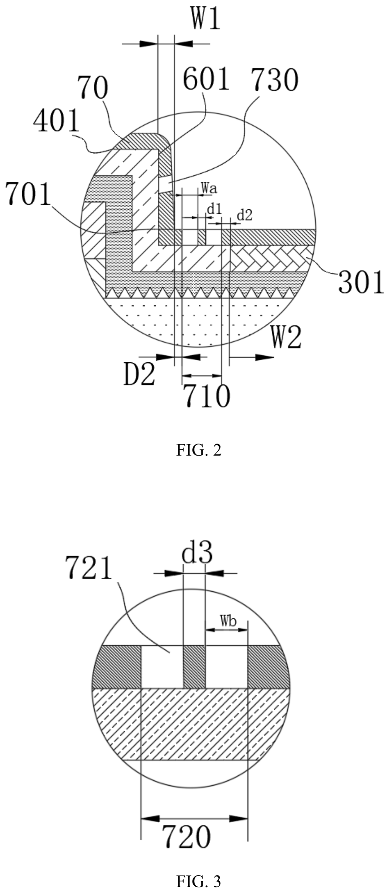

Referring to FIGS. 1 and 2, in the present application, two first isolation regions 710 are arranged spaced apart on the conductive film layer 70 at the groove bottom of the second groove 60. The first isolation region 710 includes at least one first isolation groove 711. The first isolation groove 711 interrupts the conductive film layer 70, creating an isolation segment. When the first isolation region 710 is provided with a plurality of first isolation grooves 711, the extent of the first isolation region 710 refers to a range between the edges of the first one and the last one of the first isolation grooves 711 in the same first isolation region 710 that are farthest away from each other in the X-axis direction.

Compared to the related art where the isolation region extends across the P region and the N region, in the present application, the first isolation region 710 of the conductive film layer 70 is provided within the second groove 60 on the outer surface of the second semiconductor layer 30, avoiding an excessive etching of the conductive film layer 70 which may cause a decrease in the bifaciality of the solar cell (i.e., the ratio of the power generation capabilities on the back side and the front side of the solar cell). Specifically, the second semiconductor layer 30 is a P-type semiconductor layer, with the region corresponding to the second groove 60 being the P region and the region corresponding to the first groove 50 being the N region. The first isolation region 710 is provided in the P region which has a poor lateral transmission, thereby preventing the etching of the conductive film layer 70 in the N region.

In addition, the first isolation groove 711 causes the conductive film layer 70 to form one or more isolated islands of conductive film layer in the X-axis direction, resulting in formation of localized electric leakage of the conductive film layer 70 in the first isolation region 710, which is advantageous for reducing the hot spot effect of the back contact solar cell 100. Consequently, the back contact solar cell 100 of the present application can achieve improved conversion efficiency and reduced hot spot effect.

In some embodiments, referring to FIGS. 1 and 2, a distance *d1* between two adjacent first isolation grooves 711 in the same first isolation region 710 in the X-axis direction is 5 µm to 15 µm. The distance *d1* between two adjacent first isolation grooves 711 refers to a distance between the edges of the two adjacent first isolation grooves 711 proximate to each other. The distance *d1* between two adjacent first isolation grooves 711 is, for example, 5 µm, 10 µm, or 15 µm. The distance in the above range helps prevent excessive etching of the conductive film layer 70 while forming the isolated islands of conductive film layer, resulting in the localized electric leakage, which is advantageous for reducing the hot spot effect of the back contact solar cell 100.

In some embodiments, referring to FIGS. 1 and 2, a part of the second semiconductor layer 30 between the two first isolation regions 710 in the same first groove 50 includes a crystallized microcrystalline silicon region 301. A distance d2 between the crystallized microcrystalline silicon region 301 and either of the first isolation regions 710 is less than 5 µm. The distance d2 between the crystallized microcrystalline silicon region 301 and the first isolation region 710 refers to a distance between edges of the crystallized microcrystalline silicon region 301 and the first isolation region 710 proximate to each other. The distance d2 may specifically be 0 µm, 1 µm, 3 µm, or 5 µm. This can ensure that the crystallized microcrystalline silicon region 301 has a relatively large area.

The part of the second semiconductor layer 30 between the two first isolation regions 710 is crystallized to form the crystallized microcrystalline silicon region 301. The crystallized microcrystalline silicon region 301 can improve the contact with the conductive film layer 70 and reduce the contact resistance, thereby improving the efficiency of the solar cell.

Further, referring to FIGS. 1 and 2, parts of the conductive film layer 70 on two opposite side walls 601 of the second groove 60 each form a slope inclined toward a top 401 of the overlapping region 40 adjacent thereto. In the X-axis direction, a width *D1* of the overlapping region 40 is 10 µm to 160 µm, a width *W1* of the slope is 5 µm to 20 µm, a width *Wa* of the first isolation groove 711 is 35 µm to 80 µm, and a width *W2* of the crystallized microcrystalline silicon region 301 is 300 µm to 600 µm.

In actual manufacturing, the two opposite side walls 601 of the second groove 60 and the parts of the conductive film layer 70 thereon form slopes. The width *D1* of the overlapping region 40 is 10 µm to 160 µm, such as 10 µm, 40 µm, 60 µm, 90 µm, 130 µm, 160 µm.The width *W1* of the slope is, for example, 5 µm, 8 µm, 10 µm, 12 µm, 14 µm, 16 µm, 18 µm, 20 µm. The width *Wa* of the first isolation groove 711 is, for example, 35 µm, 40 µm, 45 µm, 50 µm, 60 µm, 70 µm, 80 µm. The width W2 of the crystallized microcrystalline silicon region 301 is, for example, 300 µm, 350 µm, 380 µm, 400 µm, 450 µm, 500 µm, 580 µm, 600 µm. It has been demonstrated the sizes within the above-mentioned ranges can ensure a high efficiency of the solar cell and can also be achieved through patterning by etching process.

In some other embodiments, the part of the second semiconductor layer 30 located between the two first isolation regions 710 in the same first groove 50 may alternatively be an amorphous silicon region. When the part of the second semiconductor layer 30 located between the two first isolation regions 710 is an amorphous silicon region, the amorphous silicon region can be formed through a conventional deposition process without requiring additional processing steps in the manufacturing process, making the overall manufacturing process relatively simple.

In some embodiments, referring to FIGS. 1 and 2, the parts of the conductive film layer 70 on the two opposite side walls 601 of the second groove 60 respectively form the slopes inclined toward the tops 401 of the overlapping regions 40 adjacent thereto. The two first isolation regions 710 are each located proximate to a respective one of the slopes in the X-axis direction. The starting points of the two first isolation regions 710 are farther away from each other, while the ending points of the two first isolation regions 710 are closer to each other. A distance between either of the starting points of the first isolation regions 710 and a bottom 701 of the slope adjacent thereto is 0 µm to 3 µm.

For one of the two first isolation regions 710, the ending point thereof is closer to the other of the two first isolation regions 710 than the starting point. Referring to FIGS. 1 and 2, FIG. 2 only illustrates an enlarged schematic view of a structure of the first isolation region 710 located at the left side of the second groove 60 in FIG. 1. A structure of the first isolation region 710 located at the right side is symmetrical with the structure of the first isolation region 710 located at the left side.

A distance between the starting point of the first isolation region 710 at the left side and the slope bottom 701 of the slope at the left side is defined as *D2.* The starting point of the first isolation region 710 at the left side is an edge of the first isolation groove 711 in the first isolation region 710 located closest to the slope bottom 701 of the slope at the left side. A distance between the first isolation region 710 at the right side and the slope bottom 701 of the slope at the right side is similarly defined. Taking the first isolation region 710 at the left side as an example, the distance *D2* is, for example, 0 µm, 1 µm, and 3 µm. When the distance *D2* is 0 µm, it indicates that the starting point of the first isolation region 710 at the left side coincides with an endpoint of the second groove 60.

Through the above design, the distance between the starting point of each of the first isolation regions 710 and the slope bottom 701 of the slope adjacent thereto is 0 µm to 3 µm, which reduces the risk of electric leakage and allows the localized electric leakage to be controlled within the desired range.

Referring to FIGS. 1 and 3, the conductive film layer 70 is provided with a second isolation region 720 at a position corresponding to the top 401 of the overlapping region 40. The second isolation region 720 includes at least one second isolation groove 721 (e.g., at least two second isolation grooves 721) spaced part from each other in the X-axis direction.

At least one second isolation region 720 is provided on the conductive film layer 70 on the top 401 of the overlapping region 40. Each second isolation region 720 includes one or more second isolation grooves 721. A width *Wb* of the second isolation groove 721 in the X-axis direction is 0 µm to 80 µm. The width *Wb* of the second isolation groove 721 is, for example, 0 µm, 35 µm, 40 µm, 45 µm, 50 µm, 60 µm, 70 µm, or 80 µm. When the width of the second isolation groove 721 is 0 µm, it means that no second isolation groove 721 is provided.

The second isolation region 720 allows for the formation of an isolated island of the conductive film layer on the top 401 of the overlapping region 40, thereby achieving localized electric leakage, which is advantageous for reducing the hot spot effect of the back contact solar cell 100. As the width *Wb* of the second isolation groove 721 is Opum to 80 µm, the etching degree of the conductive film layer 70 can be reduced, avoiding the excessive etching of the transparent conductive film which may cause a decrease in the bifaciality of the solar cell.

Specifically, the distance d3 between two adjacent second isolation grooves 721 is 10 µm to 30 µm. The distance between two adjacent second isolation grooves 721 refers to a distance between edges of the two adjacent second isolation grooves 721 proximate to each other. The distance d3 between the two adjacent second isolation grooves 721 is, for example, 10 µm, 15 µm, 20 µm, 25 µm, or 30 µm. The distance in the above range helps to avoid the excessive etching of the conductive film layer 70 and allows for the formation of the isolated islands of conductive film layer, thereby forming the localized electric leakage, which is advantageous for reducing the hot spot effect of the back contact solar cell 100.

In some embodiments, referring to FIG. 2, the conductive film layer 70 is provided with a third isolation region 730 at a position corresponding to the side wall 601 of the first groove 50. The configuration of the third isolation region 730 can be completely similar to that of the first isolation region 710 or the second isolation region 720. The third isolation region 730 allows for the formation of an isolated island of conductive film layer at the side wall 601 of the first groove 50, thereby forming localized electric leakage, which is advantageous for reducing the hot spot effect of the back contact solar cell 100 and improving the conversion efficiency of the back contact solar cell 100.

In a second aspect, the present application provides a method manufacturing of a back contact solar cell 100, which can be used to manufacture the back contact solar cell 100 as described in the first aspect.

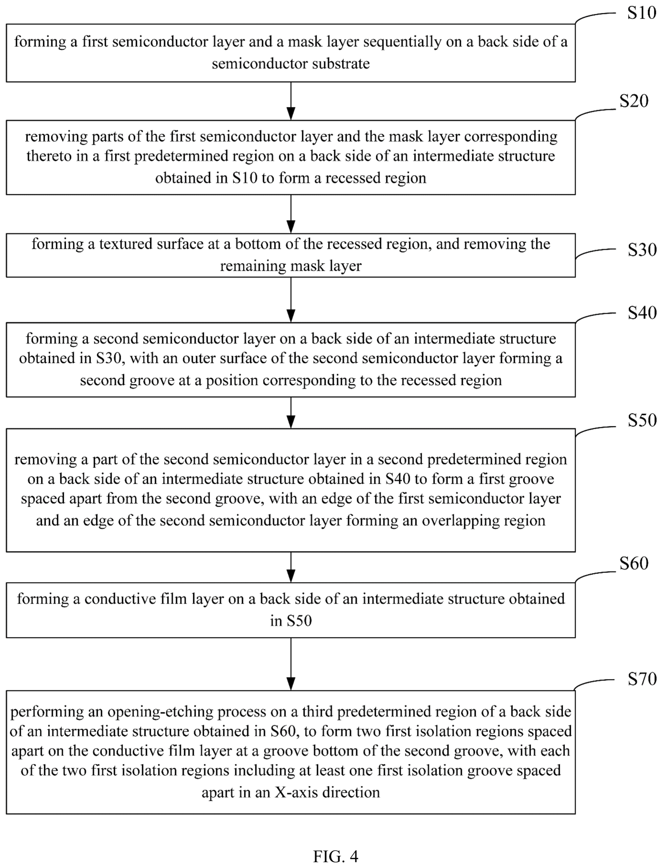

Referring to FIG. 4, the manufacturing method of the back contact solar cell 100 of the present application includes the following steps:

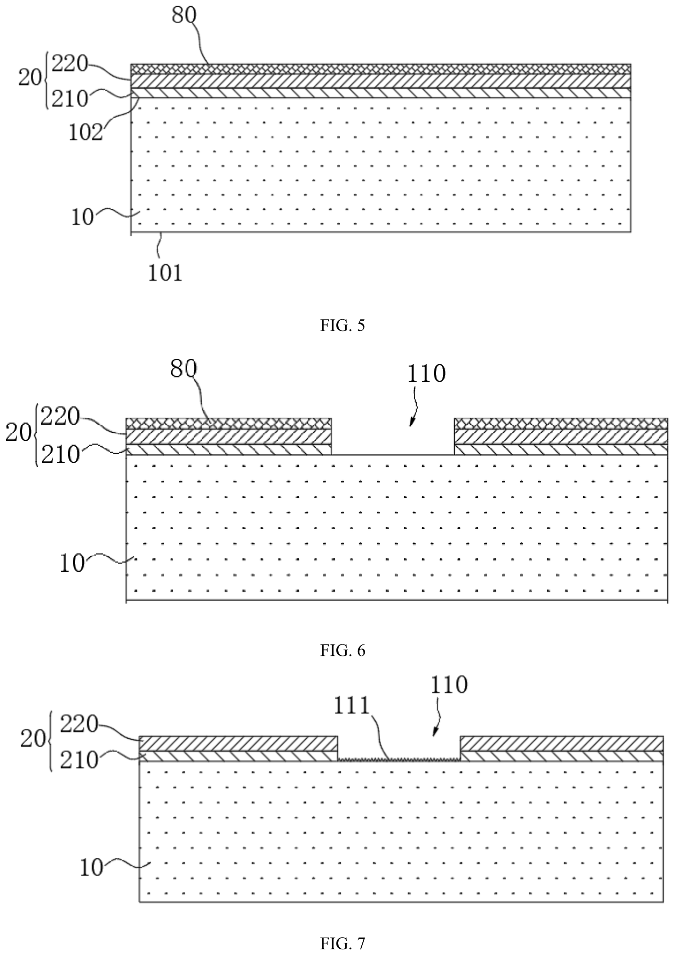

Step S10, as shown in FIG. 5, a first semiconductor layer 20 and a mask layer 80 are sequentially formed over a back side 102 of a semiconductor substrate 10.

Step S20, as shown in FIG. 6, parts of the first semiconductor layer 20 and the corresponding mask layer 80, located in a first predetermined region of a back side of an intermediate structure obtained in the step S10 are removed to form a recessed region 110.

After parts of the first semiconductor layer 20 and the mask layer 80 in the first predetermined region are removed, the recessed region 110 that expose the semiconductor substrate 10 is formed.

Step S30, referring to FIG. 7, a textured surface 111 is formed at a bottom of the recessed region 110, and the remaining part of the mask layer 80 is removed. The textured surface 111 is formed on the semiconductor substrate 10 in the recessed region 110 through a texturing and cleaning process. The remaining part of the mask layer 80 is removed through an acid washing with, for example, hydrofluoric acid.

Step S40, referring to FIG. 8, a second semiconductor layer 30 is formed over a back side of an intermediate structure obtained in the step S30, with an outer surface of the second semiconductor layer 30 forming a second groove 60 at a position corresponding to the recessed region 110.

In this step, the formed second semiconductor layer 30 covers the back side 102 of the intermediate structure obtained in the step S30. The second semiconductor layer 30 covers the side walls 601 and the bottom wall of the recessed region 110, such that the outer surface of the second semiconductor layer 30 forms the second groove 60 at the position corresponding to the recessed region 110.

Step S50, referring to FIG. 9, a part of the second semiconductor layer 30, located in a second predetermined region of a back side of an intermediate structure obtained in the step S40 are removed to form a first groove 50 spaced apart from the second groove 60, with an edge of the first semiconductor layer 20 and an edge of the second semiconductor layer 30 forming an overlapping region 40.

In this step, a part of the second semiconductor layer 30 is etched away to expose the underlying first semiconductor layer 20. The edges of the second semiconductor layer 30 at two ends thereof each cover an edge of the adjacent the first semiconductor layer 20 to form the overlapping region 40.

In the steps S40 and S50, the methods for forming the first semiconductor layer 20, the second semiconductor layer 30, and the mask layer 80 may refer to any corresponding methods in the prior art. For example, the first semiconductor layer 20 may be formed though a chemical vapor deposition process.

In the steps S40 and S50, the method for removing the parts of the corresponding semiconductor layers and their corresponding mask layers to form the corresponding recessed region 110 and first groove 50 may be laser etching, chemical etching or any other desired technologies.

Step S60, referring to FIG. 10, a conductive film layer 70 is formed over a back side of an intermediate structure obtained in the step S50.

The conductive film layer 70 covers the side walls and the bottom wall of the first groove 50, the overlapping region 40, and the side walls 601 and the bottom wall of the second groove 60.

The method for forming the conductive film layer 70 may refer to the corresponding method in the prior art. For example, the conductive film layer 70 may be formed through magnetron sputtering, evaporation deposition, ion beam evaporation, and activated plasma vapor deposition and any other desired technologies.

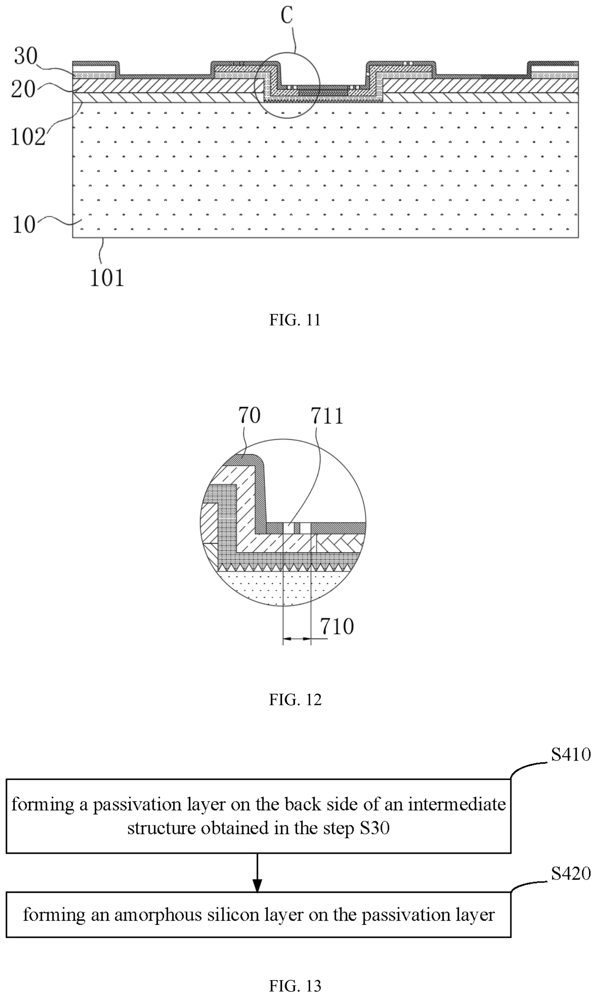

Step S70, referring to FIGS. 11 and 12, an opening-etching process is performed on a third predetermined region of a back side of an intermediate structure obtained in the step S60, to form two first isolation regions 710 spaced apart from each other on the conductive film layer 70 on a groove bottom of the second groove 60, with each of the first isolation regions 710 including at least one first isolation groove 711 spaced apart in the X-axis direction.

The first isolation groove 711 may be formed through, for example, laser, ink etching, mask etching, or any other desired technologies.

Referring to FIGS. 8 and 13, in some embodiments, the step S40 includes:

Step S410, a passivation layer 310 is formed over the back side of an intermediate structure obtained in the step S30.

Step S420, an amorphous silicon layer 320 is formed over the passivation layer 310.

The passivation layer 310 can reduce carrier recombination and optimize carrier transmission path. The material of the passivation layer 310 is, for example, a-Si:H(i), silicon oxide, etc.

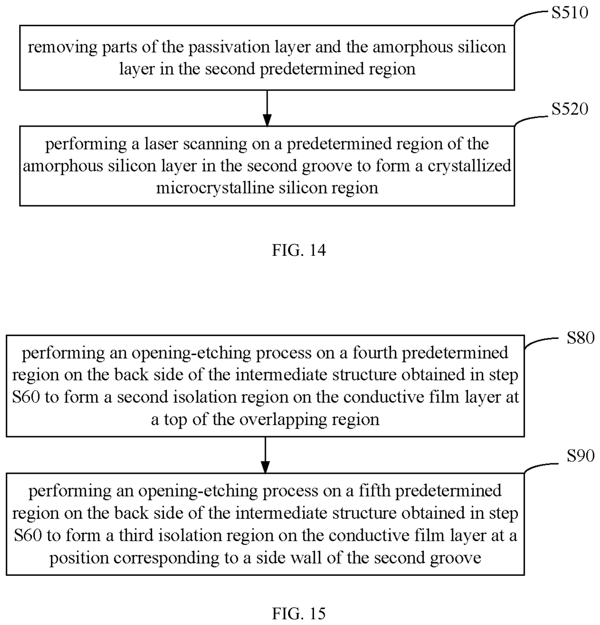

Referring to FIGS. 9 and 14, in some embodiments, the step S50 includes:

Step S510, parts of the passivation layer 310 and the amorphous silicon layer 320 in the second predetermined region are removed.

Step S520, a laser scanning is performed on a predetermined region of the amorphous silicon layer 320 in the second groove 60 to form a crystallized microcrystalline silicon region 301.

Through the etching process, the parts of the passivation layer 310 and the amorphous silicon layer 320 in the second predetermined region are removed to form the first groove 50. Additionally, a partial region of the amorphous silicon layer 320 in the second groove 60 is subjected to the laser scanning to form the crystallized microcrystalline silicon region 301.

Referring to FIGS. 1 to 3 and FIG. 15, the manufacturing method of the back contact solar cell 100 of the present application further includes the following step:

Step S80, an opening-etching process is performed on a fourth predetermined region of the back side of the intermediate structure obtained in the step S60, to form a second isolation region 720 on the conductive film layer 70 on the top 401 of the overlapping region 40.

Through the etching process, the conductive film layer 70 on the top 401 of the overlapping region 40 is grooved to form the second isolation region 720.

Referring to FIGS. 1 to 3 and FIG. 15, the method manufacturing of the back contact solar cell 100 of the present application further includes the following step:

Step S90: an opening-etching process is performed on the fifth predetermined region of the back side of the intermediate structure obtained in the step S60, to form a third isolation region 730 on the conductive film layer 70 at a position corresponding to the side wall 601 of the second groove 60.

Through the etching process, the conductive film layer 70 is grooved at the side wall 601 of the second groove 60 to form the third isolation region 730.

In some embodiments, referring to FIG. 1, the manufacturing method of the back contact solar cell 100 further includes: forming a first electrode 910 and a second electrode 920 respectively in the first groove 50 and the second groove 60 over a back side of an intermediate structure obtained in the step S70, S80, or S90. The first electrode 910 and the second electrode 920 may be formed though printing, transfer printing, electric plating, or the like.

The back contact solar cell 100 in the embodiments of the present application will be illustrated below in combination with some examples and related comparative examples.

### Example 1

Referring to FIG. 5, a semiconductor substrate 10, specifically an N-type silicon wafer, was provided. The N-type silicon wafer was cleaned and polished. A first semiconductor layer 20 was formed over a back side 102 of the N-type silicon wafer. The first semiconductor layer 20 included a tunneling oxide layer 210 and an intrinsic polysilicon layer 220 arranged sequentially over the back side 102 of the N-type silicon wafer. The intrinsic polysilicon layer 220 was subjected to a phosphorus diffusion doping process to form a phosphorus-doped polysilicon layer. Then, a mask layer 80, specifically a silicon oxide layer, was provided over the first semiconductor layer 20.

As shown in FIG. 6, a patterning treatment was performed on a back side of an intermediate structure obtained in FIG. 5 to remove parts of the first semiconductor layer 20 and the mask layer 80 in a first predetermined region to form a recessed region 110.

As shown in FIG. 7, the N-type silicon wafer was textured in the recessed region 110 to form a textured surface 111.

As shown in FIG. 8, a second semiconductor layer 30 was formed over a back side of an intermediate structure obtained in FIG. 7. The second semiconductor layer 30 included a passivation layer 310 and an amorphous silicon layer 320 arranged sequentially on the semiconductor substrate 10. The passivation layer 310 was specifically an intrinsic hydrogenated amorphous silicon (a-Si:H(i)) layer, and the amorphous silicon layer 320 was specifically a P-type doped amorphous silicon film layer. The passivation layer 310 made of the a-Si:H(i) material was deposited and formed under a low-temperature annealing condition. If the P-type doped amorphous silicon film layer was formed using AlOx or evaporated Al as a doping source, aluminum-doped amorphous silicon could be formed under the low-temperature annealing condition. The low temperature was less than 250 °C, specifically, for example, 200 °C. It should be noted that during the formation of the P-type doped amorphous silicon film layer, a dopant such as aluminum may diffuse into the a-Si:H(i) layer. Consequently, the a-Si:H(i) layer may not remain strictly intrinsic, as it could contain the dopant.

As shown in FIGS. 9 and 12, a part of the second semiconductor layer 30 at a position of a back side of an intermediate structure obtained in FIG. 8 corresponding to the first groove 50 was removed. Additionally, a laser with a wavelength of 355 nm was used to scan the back side to crystallize a part of the P-type doped amorphous silicon film layer to form a crystallized microcrystalline silicon region 301. The scanning can also be performed with a laser with a wavelength of 532 nm.

As shown in FIG. 10, a conductive film layer 70 was provided over a back side of an intermediate structure obtained in FIG. 9. The conductive film layer 70 was specifically a tin-doped indium oxide-based film.

As shown in FIGS. 11 and 12, an ink etching or a laser patterning treatment was performed on the conductive film layer 70 to form a first isolation region 710. The first isolation region 710 included at least one first isolation groove 711.

In this example, the width *D1* of the overlapping region 40 was 10 µm, the width *W1* of the slope was 5 µm, the width *Wa* of the first isolation region 710 was 35 µm, and the width W2 of the crystallized microcrystalline silicon region 301 was 300 µm. In addition, Examples 2 to 6 were carried out with reference to Example 1, with the exception of different size parameters, as detailed in Table 1.

The back contact solar cells obtained in Examples 1 to 6 were tested for performance using an IV tester and compared with the related art. The results are shown in Table 1.

**Table 1**

| | D1 | W1 | Wa | d1 | D2 | Wb | d3 | W2 | Conversion efficiency |
|---|---|---|---|---|---|---|---|---|---|
| Example 1 | 10 | 5 | 35 | 0 | 0 | 0 | 0 | 300 | 27.11 |
| Example 2 | 40 | 8 | 40 | 5 | 3 | 35 | 0 | 350 | 27.01 |
| Example 3 | 60 | 12 | 40 | 0 | 3 | 40 | 0 | 450 | 27.11 |
| Example 4 | 90 | 14 | 60 | 10 | 3 | 40 | 10 | 500 | 26.95 |
| Example 5 | 130 | 16 | 70 | 15 | 3 | 35 | 15 | 580 | 26.85 |
| Example 6 | 160 | 20 | 80 | 20 | 3 | 80 | 30 | 600 | 26.81 |
| Comparative Example 1 | -- | -- | -- | -- | -- | -- | -- | -- | 26.8 |
| Comparative Example 2 | -- | -- | -- | -- | -- | -- | -- | -- | 26.75 |
| Comparative Example 3 | -- | -- | -- | -- | -- | -- | -- | -- | 26.7 |

In Table 1, in Examples 1 and 3, both the number of the first isolation groove 711 and the number of the second isolation groove 721 are 1; in Examples 2 and 4, both the number of the first isolation groove 711 and the number of the second isolation groove 721 are 2; in Examples 5 and 6, both the number of the first isolation groove 711 and the number of the second isolation groove 721 are 3. In Table 1, Comparative Examples 1, 2 and 3 are Examples 1, 2, and 7 of CN 117577709 B in the related art, respectively.

It can be seen from the above results that, compared to the comparative examples, the back contact solar cells 100 of the examples of the present application have a higher conversion efficiency.

## Claims

1. A back contact solar cell, comprising:
a semiconductor base (10) comprising a front side (101) and a back side (102);
a first semiconductor layer (20) and a second semiconductor layer (30) alternately arranged over the back side in an X-axis direction, an edge of the first semiconductor layer and an edge of the second semiconductor layer forming an overlapping region (40) in a Z-axis direction, a first groove (50) being formed between adjacent second semiconductor layers, a second groove (60) being provided on an outer surface of the second semiconductor layer, and a conductivity type of the second semiconductor layer being opposite to a conductivity type of the first semiconductor layer; and
a conductive film layer (70) disposed over outer surfaces of the first groove, the second groove, and the overlapping region;
wherein the conductive film layer is provided with two first isolation regions (710) spaced apart from each other at a groove bottom of the second groove, and each of the two first isolation regions comprises at least one first isolation groove (711) spaced apart in the X-axis direction.

2. The back contact solar cell according to claim 1, wherein a distance between two adjacent first isolation grooves in either of the two first isolation regions in the X-axis direction is 5 µm to 15 µm.

3. The back contact solar cell according to any of the preceding claims, wherein a part of the second semiconductor layer between the two first isolation regions in the same second groove comprises a microcrystalline silicon region (301), and a distance between the microcrystalline silicon region and either of the two first isolation regions in the X-axis direction is less than 5 µm;
optionally, a width of the microcrystalline silicon region in the X-axis direction is 300 µm to 600 µm.

4. The back contact solar cell according to any of the preceding claims, wherein a width of the overlapping region in the X-axis direction is 10 µm to 160 µm, optionally, a width of the first isolation groove in the X-axis direction is 35µm to 80 µm.

5. The back contact solar cell according to any of the preceding claims, wherein a part of the second semiconductor layer between the two first isolation regions in the same second groove is an amorphous silicon region.

6. The back contact solar cell according to any of the preceding claims, wherein parts of the conductive film layer on two opposite side walls of the second groove each form a slope inclined toward a top of the overlapping region adjacent thereto;
optionally, a width of the slope in the X-axis direction is 5µm to 20 µm;
optionally, in the X-axis direction, the two first isolation regions in the same second groove are each adjacent to the respective slope, the two first isolation regions have their starting points located farther away from each other and their ending points located closer to each other, and a distance between either of the starting points of the two first isolation regions and a slope bottom of the adjacent slope is 0 µm to 3 µm.

7. The back contact solar cell according to any of the preceding claims, wherein the conductive film layer is provided with a second isolation region (720) at a position corresponding to a top of the overlapping region, and the second isolation region comprises at least one second isolation groove (721) spaced apart in the X-axis direction.

8. The back contact solar cell according to claim 7, wherein a width of the second isolation groove in the X-axis direction is 0 µm to 80 µm.

9. The back contact solar cell according to claim 7 or 8, wherein a distance between two adjacent second isolation grooves in the same second isolation region is 10 µm to 30 µm.

10. The back contact solar cell according to any of the preceding claims, wherein the conductive film layer is provided with a third isolation region (730) at a position corresponding to a side wall of the second groove.

11. A method for manufacturing a back contact solar cell, comprising:
S10, forming a first semiconductor layer (20) and a mask layer (80) sequentially over a back side (102) of a semiconductor base (10);
S20, removing parts of the first semiconductor layer and the mask layer corresponding thereto in a first predetermined region on a back side of an intermediate structure obtained in S10 to form a recessed region (110);
S30, forming a textured surface (111) at a bottom of the recessed region;
S40, forming a second semiconductor layer (30) over a back side of an intermediate structure obtained in S30, with an outer surface of the second semiconductor layer forming a second groove (60) at a position corresponding to the recessed region;
S50, removing parts of the second semiconductor layer and the mask layer corresponding thereto in a second predetermined region on a back side of an intermediate structure obtained in S40 to form a first groove (50) spaced apart from the second groove, with an edge of the first semiconductor layer and an edge of the second semiconductor layer forming an overlapping region (40);
S60, forming a conductive film layer (70) over a back side of an intermediate structure obtained in S50;
S70, performing an opening-etching process on a third predetermined region of a back side of an intermediate structure obtained in S60, to form two first isolation regions (710) spaced apart on the conductive film layer at a groove bottom of the second groove, with each of the two first isolation regions comprising at least one first isolation groove (711) spaced apart in an X-axis direction.

12. The method for manufacturing the back contact solar cell according to claim 11, wherein S40 comprises:
forming a passivation layer (310) over the back side of the intermediate structure obtained in S30; and
forming an amorphous silicon layer (320) on the passivation layer.

13. The method for manufacturing the back contact solar cell according to claim 12, wherein S50 comprises:
removing parts of the passivation layer and the amorphous silicon layer in the second predetermined region;
performing a laser scanning on a predetermined region of the amorphous silicon layer in the second groove to form a microcrystalline silicon region (301).

14. The method for manufacturing the back contact solar cell according to any one of claims 11 to 13, further comprising:
performing an opening-etching process on a fourth predetermined region on the back side of the intermediate structure obtained in S60 to form a second isolation region (720) on the conductive film layer at a top of the overlapping region.

15. The method for manufacturing the back contact solar cell according to any one of claims 11 to 14, further comprising:
performing an opening-etching process on a fifth predetermined region on the back side of the intermediate structure obtained in S60 to form a third isolation region (730) on the conductive film layer at a position corresponding to a side wall of the second groove.
